# EUROPÄISCHE PATENTSCHRIFT

(11) **EP 0 717 588 B1**
(45) Veröffentlichungstag und Bekanntmachung des Hinweises auf die Patenterteilung: **26.02.2003**
(21) Anmeldenummer: 95116661.0
(22) Anmeldetag: 23.10.1995
(51) Int. Cl.: H05K 5/00, B60R 16/02, H05K 5/06

(54) **Gehäuse für ein elektrisches Bauteil**
Casing for an electrical device
Boîtier pour un dispositif électrique

(30) Priorität: 17.12.1994 DE 4445125
(43) Veröffentlichungstag der Anmeldung: 19.06.1996
(73) Patentinhaber: WABCO GmbH & Co. OHG, 30453 Hannover (DE)
(72) Erfinder: Hein, Dierk, D-30169 Hannover (DE); Teichmann, Andreas, D-30916 Isernhagen (DE); Gröger, Jens, D-30449 Hannover (DE)
(74) Vertreter: Schrödter, Manfred, Dipl.-Ing.

(56) Entgegenhaltungen:
- DE-A- 3 307 654
- DE-A- 4 240 755
- FR-A- 2 655 809
- US-A- 5 184 283

## Beschreibung

Die Erfindung betrifft ein Gehäuse für ein elektrisches Bauteil gemäß dem in den Patentansprühen 1 und 2 angegebenen Oberbegriff.

Ein derartiges Gehäuse ist aus der DE-A-33 07 654 bekannt.

Das bekannte Gehäuse besteht aus einem ersten Gehäuseteil und einem zweiten Gehäuseteil, die miteinander verbunden sind. Zwischen den beiden Gehäuseteilen ist ein als Zwischenboden ausgebildeter Gehäuserahmen angeordnet, der als Träger für ein elektrisches Bauteil, wie z.B. eine Leiterplatte, dient. Zur Verbindung des im Gehäuse gelegenen elektrischen Bauteiles mit einem außerhalb des Gehäuses befindlichen elektrischen Bauteil dienen Steckerstifte, die an dem Gehäuserahmen angeordnet sind.

Zwischen dem ersten Gehäuseteil und der diesem zugewandten Seite des Gehäuserahmens ist eine erste Dichtung angeordnet und zwischen dem zweiten Gehäuseteil und der diesem zugewandten anderen Seite des Gehäuserahmens ist eine zweite Dichtung angeordnet. Von dem ersten Gehäuseteil, der ersten Dichtung und der als Träger für das elektrische Bauteil dienenden Gehäusewand wird eine geschlossene Kammer gebildet, in welcher das elektrische Bauteil vor Schmutz und Feuchtigkeit geschützt gelegen ist.

Zum Verbinden des ersten Gehäuseteiles und des Gehäuserahmens mit dem zweiten Gehäuseteil sind an den beiden Gehäuseteilen und an dem Gehäuserahmen Befestigungsanschlüsse vorgesehen, über welche die beiden Gehäuseteile und der Gehäuserahmen miteinander verbunden sind.

Bei derartigen Gehäusen ist es nicht ganz auszuschließen, daß von den Befestigungsmilteln, wie z.B. Schrauben, die durch Öffnungen in den Befestigungsanschlüssen hindurchgeführt und in den Montageort eingedreht sind, die auf die Befestigungsanschlüsse ausgeübten Kräfte oder auch am Montageort möglicherweise auftretende Verwindungskräfte auf den Gehäuserahmen und somit auf das elektrische Bauteil ausgeübt werden.

Der Erfindung liegt deshalb die Aufgabe zugrunde, ein Gehäuse der eingangs erwähnten Art zu schaffen, welches so ausgebildet ist, daß die mechanische Belastung eines im Gehäuse befindlichen elektrischen Bauteils verringert und ein guter Schutz des elektrischen Bauteils gegen Schmutz etc. erzielt wird.

Diese Aufgabe wird mit den in den Patentansprüchen 1 und 2 angegebenen Erfindungen gelöst. Weiterbildungen und vorteilhafte Ausgestaltungen der Erfindungen sind in den Unteransprüchen angegeben.

Die Erfindungen bieten insbesondere den Vorteil, durch die Trennung von Träger und Befestigungsanschluß sowie die Anordnung einer elastisch oder plastisch verformbaren Dichtung direkt zwischen dem Träger und wenigstens einem der beiden Gehäuseteile, die mechanische Belastung des Trägers, der vorzugsweise als Rahmen ausgebildet ist, und somit des mit diesem verbundenen elektrischen Bauteiles im Gehäuse sehr gering zu halten und eine gute Abdichtung der zur Aufnahme des elektrischen Bauteiles dienenden Kammer des Gehäuses zu erhalten. Die Höhe des Trägers und die Höhe der Seitenwand bzw. der Seitenwände des Gehäuses ist so bemessen, daß bei geschlossenem Gehäuse wenigstens zwischen dem einen Gehäuseteil und der diesem zugewandten Seite des Trägers ein Spalt zur Aufnahme der Dichtung verbleibt. Die Verbindung der beiden Gehäuseteile miteinander und mit dem Träger ist bei dem erfindungsgemäßen Gehäuse wesentlich stabiler als bei einem aus Kunststoff bestehenden Gehäuse, da die aus Metall bestehenden Gehäuseteile direkt oder über ein ebenfalls metallisches starres Zwischenstück miteinander verbunden sind. Die Probleme, die durch Fließen eines zwischen zwei Gehäuseteilen eingespannten Trägers aus Kunststoff verursacht werden, treten deshalb bei dem erfindungsgemäßen Gehäuse nicht auf. Da der Befestigungsanschluß an dem mechanisch stabileren, aus Metall bestehenden Gehäuseteil angeordnet ist, kann er auch wesentlich höhere Befestigungskräfte übertragen als ein an einem Kunststoffteil angeordneter Befestigungsanschluß. Es ist deshalb möglich, das Gewicht des Gehäuses (mit Bauteilen) erhöhende Bauteile, wie z. B. Pneumatik- bzw. Hydraulikbausteine, zusätzlich zu dem elektrischen Bauteil im Gehäuse anzuordnen.

Ein weiterer Vorteil des erfindungsgemäßen Gehäuses gegenüber dem bekannten Gehäuse ist auch darin zu sehen, daß ein teures Galvanisieren der Gehäuseteile entfällt und trotzdem eine hohe EMV-Festigkeit gewährleistet ist.

Sind im Gehäuse elektrische Leistungsbauelemente angeordnet, deren Wärme über einen Kühlkörper abgeführt werden soll, braucht der Kühlkörper gemäß der Erfindung nicht durch den aus Kunststoff bestehenden Träger hindurch aus dem Gehäuse herausgeführt zu werden, da er an einem der beiden aus Metall bestehenden Gehäuseteile angeordnet bzw. mit einem der beiden Gehäuseteile verbunden ist, und zwar mit einem Bereich eines der beiden Gehäuseteile, der die abgedichtete Kammer zur Aufnahme des elektrischen Bauteiles begrenzt. Eine zusätzliche Abdichtung einer Durchführung für den Kühlkörper ist somit nicht erforderlich.

Gemäß einer vorteilhaften Ausgestaltung der Erfindungen ist an wenigstens einem der beiden Gehäuseteile eine als umlaufende Nut ausgebildete Dichtkontur zur Aufnahme der Dichtung vorgesehen, in welche ein Teil des Trägers eintaucht. Die Tiefe der Nut und der in diese eintauchende Bereich des Trägers sind so bemessen, daß die in der Nut angeordnete Dichtung, die vorzugsweise einen kreisförmigem Querschnitt aufweist, beim Verbinden der beiden Gehäuseteile miteinander vom Träger elastisch so weit verformt wird, daß sie an den Nutflanken unter leichter Vorspannung anliegt.

Die Dichtkontur an dem anderen Gehäuseteil ist gemäß einer vorteilhaften Ausgestaltung der Erfindung als Stufe ausgebildet, die zusammen mit einer am Träger angeordneten Stufe den Spalt zur Aufnahme der Dichtung bildet.

Der als Rahmen ausgebildete Träger weist vorteilhafterweise eine umlaufende Versteifungsrippe auf, die sich in den vom Träger begrenzten Raum hineinerstreckt.

Gemäß einer vorteilhaften Weiterbildung der Erfindungen sind die elektrischen Anschlußmittel zur Verbindung des im Gehäuse gelegenen elektrischen Bauteiles mit einem außerhalb des Gehäuses gelegenen elektrischen Bauteil als in den Träger und die Versteifungsrippe eingeformte Steckerstifte oder Steckerbuchsen ausgebildet. An den Träger ist eine die Steckerstifte bzw. die Steckerbuchsen umgebende Steckerkontur angeformt, die sich von der Außenseite des Trägers weg durch eine Öffnung des Gehäuses hindurch erstreckt. Die Versteifungsrippe weist im Bereich der Steckerstifte fensterartige Ausnehmungen auf. Dadurch wird der Vorteil erzielt, einen Prüfvorgang von einer Seite des geöffneten Gehäuses aus durchführen zu können, ohne daß die Position des Gehäuses oder die Position der Prüfeinrichtung verändert werden muß.

Gemäß einer weiteren vorteilhaften Weiterbildung der Erfindung weist das im Gehäuse befindliche elektrische Bauteil im Bereich der Befestigungsmittel für den Träger eine elektrisch leitende Kontaktstelle auf, die so zu dem Gehäuseteil, an welchem der Träger befestigt ist, angeordnet ist, daß sie mit diesem Gehäuseteil bei montiertem Träger eine elektrisch leitende Verbindung bildet.

Anhand der Zeichnung wird nachfolgend ein Ausführungsbeispiel der Erfindung näher erläutert.

Es zeigen:
- Fig. 1: ein Gehäuse mit Rahmen und Leiterplatte im Schnitt und
- Fig. 2: eine Draufsicht auf den Rahmen des in Fig. 1 gezeigten Gehäuses.

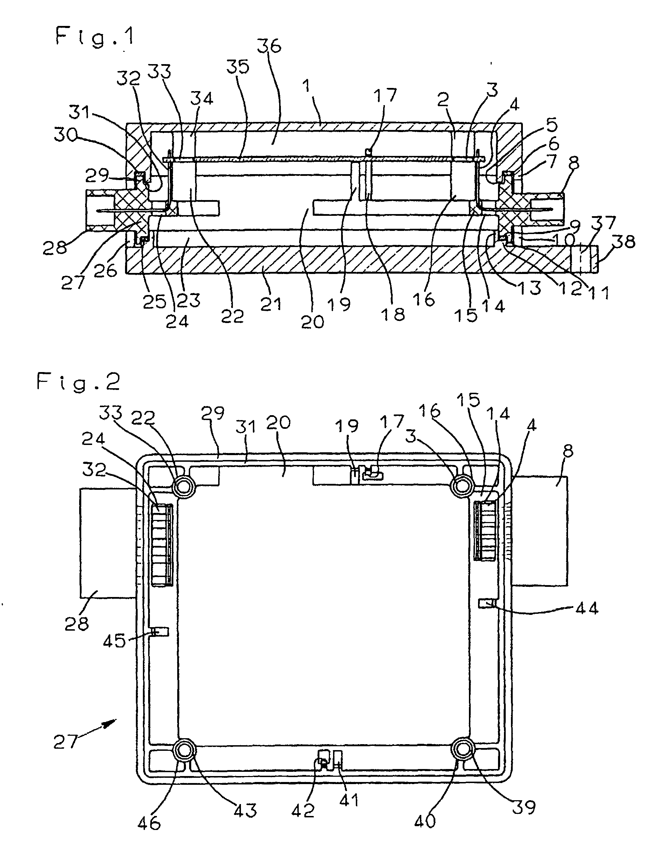

Das in Fig. 1 gezeigte Gehäuse besteht aus einem als Bodenteil (21) des Gehäuses dienenden, plattenartig ausgebildeten ersten Gehäuseteil und einem als Deckelteil (1, 7) des Gehäuses dienenden, topfförmig ausgebildeten zweiten Gehäuseteil. Das Bodenteil (21) und das Deckelteil (1, 7) sind mittels nicht dargestellter Verbindungsmittel, wie z. B. Schrauben, miteinander verbunden. Das Bodenteil (21) besitzt einen umlaufenden Vorsprung (23), der sich in Richtung auf das Deckelteil (1) zu erstreckt. per Vorsprung (23) weist auf seiner dem Gehäuseinnenraum abgewandten Seite eine Stufe (12, 13) auf.

Das Deckelteil (1, 7) ist so bemessen, daß seine umlaufende Seitenwand (7) den umlaufenden Vorsprung (23) des Bodenteiles (21) übergreift, wobei die Seitenwand (7) mit ihrer Stirnfläche auf dem Bodenteil (21) aufliegt und bündig mit der Außenkante des Bodenteiles (21) abschließt. In einer Stufe (5) der Seitenwand (7) ist eine umlaufende nutartige Vertiefung (6) angeordnet. Die Stufe (12, 13) des Bodenteiles (21) und die nutartige Vertiefung (6) des Deckelteiles (1, 7) sind einander gegenüber gelegen. Das Gehäuse (21, 1, 7) besteht aus Metall und weist eine rechteckige Form auf.

Im Gehäuse (21, 1, 7) ist ein als Träger für ein elektrisches Bauteil dienender rechteckiger Rahmen (27) aus Kunststoff angeordnet. Der Rahmen (27) besitzt einen als Versteifungsrippe (15) dienenden umlaufenden Vorsprung, der sich im wesentlichen parallel zum Bodenteil (21) und zum Deckelteil (1, 7) verlaufend in den vom Rahmen (27) begrenzten Raum hineinerstreckt.

Die Versteifungsrippe (15) weist vier fließend ineinander übergehende Teilbereiche auf, wobei je ein Teilbereich je einem Schenkel des Rahmens (27) zugeordnet ist. An den vier Übergangsbereichen (Ecken) der Versteifungsrippe (15) sind vier sich auf das Deckelteil (1, 7) zu erstrekkende Stützen (16) und (22) angeformt. In der Zeichnung sind lediglich zwei Stützen dargestellt. Jede der Stützen (16) und (22) weist an ihrem freien Ende einen abgestuften Bereich (3) bzw. (33) auf. Die Stützen (16) und (22) dienen als Auflager für das als Leiterplatte (35) ausgebildete elektrisches Bauteil. Die Leiterplatte (35) weist in ihren vier Eckbereichen Durchgangsöffnungen auf, mit welchen sie auf die abgestuften Endbereiche (3) und (33) der Stützen (16) und (22) aufgeschoben ist. Den freien Enden der Stützen (16) und (22) gegenüber sind im Deckelteil (1, 7) sich auf die Stützen (16) und (22) zu erstreckende Vorsprünge (2) und (34) angeordnet. Die Höhe der abgestuften Bereiche (3) und (33) der Stützen (16) und (22) ist geringer als die Dicke der Leiterplatte (35) und die Vorsprünge (2, 34) sowie die Stützen (16, 22) sind in ihrer axialen Erstreckung so bemessen, daß die Leiterplatte von diesen gehalten wird.

Die Vorsprünge (2) und (34) können auch in Richtung ihrer Längsachse verlaufende mit Gewinde versehene Sackbohrungen aufweisen. Gleichachsig mit den Sackbohrungen der Vorsprünge (2) und (34) sind dann in den Stützen (16) und (22) Durchgangsbohrungen angeordnet, die zur Aufnahme von Schrauben dienen, welche von der den Vorsprüngen (2) und (34) abgewandten Seite der Stützen (16) und (22) aus in die Durchgangsbohrungen eingeführt und in die Sackbohrungen der Vorsprünge (2) und (34) eingedreht sind. Mittels der als Schrauben ausgebildeten Verbindungselemente ist dann der Rahmen (27) am Deckelteil (1, 7) des Gehäuses (21, 1, 7) befestigt.

Die Stützen (16, 22) und die Vorsprünge (2, 34) dienen als Abstützmittel für den das elektrische Bauteil tragenden Träger.

Im Bereich der Durchgangsöffnungen der Leiterplatte (35) ist auf der Leiterplatte ein elektrisch leitendes Mittel, wie z. B. Lötzinn, angeordnet, an welchem die Vorsprünge (2, 34) des Deckelteiles (1) des Gehäuses (21, 1, 7) anliegen. Auf diese Art und Weise ist eine kostengünstige EMV-Anbindung des elektrischen Bauteiles (35) an das Gehäuse erreicht.

Um nach der Bestückung der Leiterplatte (35) mit elektrischen Bauteilen die erforderlichen Lötverbindungen in einer automatisch arbeitenden Anlage mit Lötwelle herstellen zu können, sind am Rahmen (27) als Montagehilfe dienende, in der gleichen Richtung wie die Stützen (16) und (22) verlaufende Distanzstücke (19) an der Versteifungsrippe (23) angeordnet, die beim Lötvorgang ein Überdrücken (Durchbiegen) der Leiterplatte (35) verhindern. Um die Leiterplatte (35) beim Lötvorgang am Rahmen (27) halten zu können, sind an der Versteifungsrippe (15) sich in derselben Richtung wie die Distanzstücke (19) erstreckende, elastisch verformbare Vorsprünge (18) mit Rastnasten (17) angeordnet, wobei die Rastnasen (17) die Leiterplatte (35) übergreifen.

Der Rahmen (27) weist auf seiner dem Bodenteil (21) zugewandten Seite eine Stufe (9, 11) auf, die der Stufe (12, 13) des umlaufenden Vorsprungs (23) des Bodenteiles (21) gegenüberliegt. Die als eine erste Dichtkontur des Rahmens (27) dienende Stufe (9, 11) und die als Dichtkontur des Bodenteiles (21) dienende Stufe (12, 13) sind einander zugewandt und begrenzen so einen Spalt zur Aufnahme eines ersten Dichtringes (25). Der Rahmen (27) und der umlaufende Vorsprung des Bodenteiles (21) sowie die Stufe (9, 11) des Rahmens (27) und die Stufe (12, 13) des Vorsprungs (23) sind so bemessen, daß der sich in Richtung auf das Bodenteil (21) zu erstreckende Schenkel (11) der Stufe (9, 11) des Rahmens (27) den Vorsprung (23) auf seiner Außenseite übergreift und der sich in Richtung auf das Deckelteil (1, 7) zu erstreckende Schenkel (13) der Stufe (12, 13) des am Bodenteil (21) angeordneten Vorsprungs (23) die Innenseite des Rahmens (27) übergreift. Durch diese Maßnahme ist der Rahmen auf dem Bodenteil (21) zentriert.

Auf seiner dem Deckelteil (1, 7) zugewandten Seite besitzt der Rahmen (27) ebenfalls eine auf der Rahmeninnenseite gelegene Stufe (29, 31), wobei der parallel zur Seitenwand (7) des Deckelteiles (1, 7) des Gehäuses (21, 1, 7) verlaufende Schenkel (29) des abgestuften Bereiches des Rahmens (27) sich in die nutartige Vertiefung (6) des Deckelteiles (1, 7) hineinerstreckt. Von dem Schenkel (29) des Rahmens (27) und den die nutartige Vertiefung (6) begrenzenden Wandungen des Deckelteiles (1, 7) wird ein Spalt zur Aufnahme eines zweiten Dichtringes (30) begrenzt. Das Deckelteil (1, 7) wird von der Außenseite des Rahmens (27) zentriert. Auf eine Abstufung dieser Seite des Rahmens (27) kann verzichtet werden. Die nutartige Vertiefung (6) in der Seitenwand (7) des Deckelteiles (1, 7) ist dann breiter auszubilden.

Die Höhe des Rahmens (27) ist so bemessen, daß bei geschlossenem Gehäuse (21, 1, 7) sowohl zwischen dem Grund der nutartigen Vertiefung (6) des Deckelteiles (1, 7) und der diesem zugeordneten Stirnseite des Rahmens (27) als auch zwischen der Stufe (12, 13) des Vorsprungs (23) des Bodenteiles (21) des Gehäuses (21, 1, 7) und der Stufe (9) der dieser zugeordneten Stirnseite des Rahmens (27) ein Spalt zur Aufnahme der Dichtung (30) bzw. (25) verbleibt.

Durch diese Maßnahme ist sichergestellt, daß beim Verbinden von Deckelteil (1, 7) und Bodenteil (21) des Gehäuses (21, 1, 7) miteinander und auch beim Befestigen des Gehäuses an einem Montageort keine großen Kräfte auf den Rahmen (27) ausgeübt werden. Zwischen Rahmen (27) und Deckelteil (1, 7) des Gehäuses (21, 1, 7) sowie zwischen Rahmen (27) und Bodenteil (21) des Gehäuses (21, 1, 7) liegen unter Vorspannung lediglich die beiden als O-Ringe ausgebildeten Dichtungen (30) und (25).

An den Rahmen (27) sind sich nach außen, vom Rahmen (27) weg, erstreckende domartige Steckerkonturen (8) und (28) angeformt, die sich durch Öffnungen (10) und (26) in der Seitenwand (7) des Deckelteiles (1, 7) aus dem Gehäuse (21, 1, 7) heraus erstrecken. In den Rahmen (27) und die Versteifungsrippe (15) sind im Bereich der Steckerkonturen (8) und (28) Steckerstifte (4) und (32) eingeformt, die sich in die domartigen Steckerkonturen (8) bzw. (28) hineinerstrecken und deren im Gehäuse (21, 1, 7) gelegener Teil im Bereich der Versteifungsrippe (15) in Richtung auf das Deckelteil (1, 7) zu abgewinkelt ist. Die Versteifungsrippe (15) weist im Bereich der Steckerstifte (4) und (32) fensterartige Öffnungen (14) und (24) auf, durch welche ein Teilbereich von jedem Steckerstift (4) bzw. (32) bei abgenommenem Deckelteil (1, 7) oder bei abgenommenem Bodenteil (21) des Gehäuses (21, 1, 7) zugänglich ist. Der abgewinkelte Teil jedes Steckerstiftes (4) bzw. (32) ist mit seinem Ende durch eine ihm zugeordnete Durchgangsöffnung in der Leiterplatte (35) hindurchgeführt und über ein elektrisch leitendes Element mit einer Leiterbahn verbunden. Die Leiterplatte (35) kann so bemessen sein, daß sie die fensterartigen Öffnungen (14) und (24) in der Versteifungsrippe (15) nicht vollständig abdeckt, so daß die Steckerstifte (4) und (32) bei montierter Leiterplatte (35) von beiden Seiten des Rahmens (27) aus für eine Prüfeinrichtung zugänglich sind.

Die Versteifungsrippe (15) des Rahmens (27) weist eine Ausnehmung (20) auf, durch welche sich ein am Bodenteil (21) des Gehäuses (21, 1, 7) angeordneter Kühlkörper, der in der Zeichnung nicht dargestellt ist, hindurch oder in diese hinein in Richtung auf die Leiterplatte (35) zu erstrecken kann, der dann so zu bemessen ist, daß er an einem metallischen Teil eines auf der Leiterplatte (35) angeordneten Leistungsbausteines anliegt.

Da die Abdichtung des Bereiches des Gehäuseinnenraumes, in welchem die elektrischen Bauteile gelegen sind - abgedichtete Kammer (36) des Gehäuses (21, 1, 7) -, direkt zwischen Deckelteil (1, 7) und Rahmen (27) sowie zwischen Bodenteil (21) und Rahmen (27) erfolgt und die Stecker (Steckerkonturen (8, 28) und Steckerstifte (4, 32)) an den Rahmen (27) angeformt bzw. in diesen eingeformt sind, ist eine Abdichtung zwischen Deckelteil (1, 7) und Bodenteil (21) nicht mehr erforderlich. Am Bodenteil (21) sind als Befestigungsanschlüsse (37, 38) für das Gehäuse (21, 1, 7) an einem Montageort dienende, sich seitlich vom Gehäuse (21, 1, 7) weg erstreckende, Vorsprünge (38) vorgesehen, die eine Durchgangsöffnung (37) zur Aufnahme eines Befestigungsmittels, wie z. B. einer Schraube, aufweisen. In der Zeichnung ist der Einfachheit halber nur ein Befestigungsanschluß dargestellt.

Es ist auch möglich, sowohl am Deckelteil (1, 7) als auch am Bodenteil (21) solche als Befestigungsanschlüsse dienenden Vorsprünge anzuordnen. Ebenso können die Befestigungsanschlüsse von die beiden Gehäuseteile durchdringenden Durchgangsöffnungen gebildet werden. Auf Vorsprünge kann dann verzichtet werden.

In Fig. 2 ist eine Draufsicht auf den im vorstehenden bereits beschriebenen Rahmen (27) dargestellt. Der besseren Übersicht halber sind die den in Fig. 1 gezeigten Bauteilen gleichen Bauteile mit gleichen Bezugsziffern versehen.

Wie bereits erwähnt, ist der Rahmen (27) rechteckig ausgebildet und weist eine sich nach innen erstreckende umlaufende Versteifungsrippe (15) auf, die einstückig mit dem Rahmen (27) ausgebildet ist. Die Versteifungsrippe (15) weist vier fließend ineinander übergehende Teilbereiche auf, wobei je ein Teilbereich je einem Schenkel des Rahmens (27) zugeordnet ist. An den vier Übergangsbereichen (Ecken) der Versteifungsrippe (15) sind die vier Stützen (16, 22, 40 und 46) angeordnet, die einstückig mit der Versteifungsrippe (15) ausgebildet sind. Jede der vier Stützen (16, 22, 40, 46) weist an ihrem freien Endbereich einen abgestuften Bereich (3) bzw. (33) bzw. (39) bzw. (43) auf, auf den die Leiterplatte mit ihren Durchgangsöffnungen aufgeschoben wird. Deutlich erkennbar sind die in der Versteifungsrippe (15) angeordneten fensterartigen Öffnungen (14, 24) im Bereich der Steckerstifte (4, 32). Zur Vereinfachung des Umspritzvorganges sind die Steckerstifte (4) bzw. (32) je eines Steckers durch hier nicht dargestellte Stege miteinander verbunden. Die Stege werden nach Fertigstellung des Rahmens (27) mittels eines Stanzwerkzeuges, welches durch die fensterartigen Öffnungen (14, 24) hindurchgeführt wird, entfernt.

Mittels der Distanzstücke (19), (41), (44) und (45) wird ein Überdrücken der Leiterplatte beim Lötvorgang verhindert. Die mit Rastnasen (17) bzw. (42) versehenen Vorsprünge dienen, wie bereits erwähnt, zum Fixieren der Leiterplatte am Rahmen beim Lötvorgang bzw. bei der Montage.

Eines der beiden Gehäuseteile, vorzugsweise das Bodenteil (21), kann von einem Gehäuse oder Gehäuseteil eines Gerätes, wie z. B. eines elektrisch oder elektromagnetisch betätigbaren Regelventils, gebildet werden, so daß lediglich der Rahmen (27) und das Deckelteil (1, 7) vormontiert zu werden brauchen und das dann bereits mit dem Rahmen (27) verbundene Deckelteil (1, 7) auf den das Bodenteil (21) für das Gehäuse (21, 1, 7) bildenden Bereich des Gerätes aufgesetzt und mit diesem verbunden wird.

Das Gehäuse und der Rahmen können selbstverständlich auch eine von der Rechteckform abweichende Form haben, wie z. B. Vieleck-, Kreis-, Ovalform usw. Zwischen dem ersten Gehäuseteil und dem zweiten Gehäuseteil kann ein als Distanzstück dienendes Zwischenstück, welches aus einem starren Werkstoff besteht, angeordnet werden. Die beiden Gehäuseteile sind dann über dieses Zwischenstück miteinarder verbunden, wobei die je einer Seite des Zwischenstückes zugeordneten Seiten der beiden Gehäuseteile an dem Zwischenstück anliegen.

Von besonderer Bedeutung für die Erfindung ist es, daß der Rahmen im Gehäuse angeordnet ist, die Abdichtung des vom Rahmen begrenzten Raumes zwischen dem Rahmen und den beiden Gehäuseteilen erfolgt, und daß die Höhe des Rahmens und die Höhe der Seitenwand bzw. der Seitenwände des Gehäuses so bemessen ist, daß die beiden Gehäuseteile mit ihren einander zugewandten Stirnseiten aneinander oder an einem zwischen den beiden Gehäuseteilen angeordneten Zwischenstück anliegen und daß zwischen den beiden einander abgewandten Stirnflächen des Rahmens und den diesen zugeordneten Gehäuseteilen ein Spalt zur Aufnahme der Dichtungen verbleibt. Bis auf das aus dem Gehäuse herausragende Teil des Steckerstiftes bzw. der Steckerstifte ist das vom Rahmen getragene elektrische Bauteil innerhalb der vom Rahmen, den beiden Gehäuseteilen und den beiden Dichtungen gebildeten geschlossenen Kammer des Gehäuses gelegen. Das elektrische Bauteil ist auch dann als innerhalb der vom Rahmen begrenzten Kammer des Gehäuses gelegen anzusehen, wenn es die Rahmenhöhe überragt, das heißt, wenn es sich in Richtung auf das Bodenteil oder/und das Deckelteil des Gehäuses zu über den Rahmen hinauserstreckt.

Selbstverständlich können anstelle von Steckerstiften auch Steckerbuchsen in den Rahmen und in die Versteifungsrippe eingeformt werden.

Das elektrische Bauteil kann, wie beschrieben, eine Leiterplatte sein. Es kann aber auch ein Verbinder für elektrische Leitungen oder eine beliebige andere elektrische oder elektronische Einrichtung sein.

Dadurch, daß das Gehäuse aus Metall besteht und das elektrische Bauteil über ein elektrisch leitendes Element mit dem Gehäuse verbunden ist, ist auf einfache Art und Weise eine gute Masseverbindung herstellbar und ein guter EMV-Schutz für das elektrische Bauteil im Gehäuse gewährleistet.

Die Dichtkonturen am Rahmen und an den Gehäuseteilen können als Stufen, Erhöhungen oder Vertiefungen an dem einen Bauteil und als mit diesen zusammenwirkende Stufen, Vertiefungen oder Erhöhungen an dem anderen Bauteil ausgebildet sein. Die Auflageflächen für die Dichtungen können eben oder konvex bzw. konkav gewölbt sein.

Besonders vorteilhaft ist es, wenn die Dichtkontur an dem einen Bauteil als nutartige Vertiefung und die Dichtkontur an dem anderen Bauteil als Erhöhung ausgebildet ist, die in die Vertiefung eintaucht oder wenn die Dichtkonturen an beiden Bauteilen als Stufen ausgebildet sind, die so zueinander angeordnet sind, daß sie einen Raum zur Aufnahme einer Dichtung begrenzen.

Es ist auch möglich, den Träger für das elektrische Bauteil als Platte oder als mit einem Boden versehenen Rahmen auszubilden. Es ist dann nur zwischen der das elektrische Bauteil tragenden Seite des Trägers und dem dieser Seite zugeordneten Gehäuseteil eine Dichtung anzuordnen.

Von der das elektrische Bauteil tragenden Seite des Trägers, der Dichtung und dem dieser Seite des Trägers zugeordneten Gehäuseteil wird dann die geschlossene Kammer gebildet, in der das elektrische Bauteil angeordnet ist.

Weist der Rahmen kein Bodenteil auf, so muß zwischen den einander abgewandten Stirnseiten des Rahmens und den diesen zugeordneten Gehäuseteilen je eine Dichtung angeordnet werden. Die geschlossene Kammer zur Aufnahme des elektrischen Bauteiles wird dann von den beiden Gehäuseteilen, dem Rahmen und den beiden Dichtungen gebildet.

Ein besonderer Vorteil der zuletzt erwähnten Ausführungsform der Erfindung ist auch darin zu sehen, daß der Träger für das elektrische Bauteil zwischen zwei elastischen Bauteilen, nämlich den beiden Dichtungen gelagert ist, wodurch der Träger und auch das elektrische Bauteil sehr wirkungsvoll gegen mechanische Einwirkung (z. B. Schwingungen) geschützt ist.

Ein solcher Schutz ist natürlich im begrenzten Rahmen auch dann gegeben, wenn nur zwischen der einen Seite des Trägers und dem dieser Seite zugeordneten Gehäuseteil ein elastisches Bauteil, nämlich eine Dichtung, angeordnet ist. Zweckmäßigerweise sollten dann die Mittel zum Abstützen des Trägers an dem anderen Gehäuseteil aus einem elastisch verformbaren Material bestehen - z. B. Metall-, Kunststoff- oder Gummifederelemente.

Ist die Dichtung bzw. sind die Dichtungen elastisch verformbar, hat bzw. haben Sie beim Gegenstand der Erfindung eine Doppelfunktion, nämlich die Funktion eines elastischen Lagerelementes und die Dichtfunktion.

Die Dichtung bzw. die Dichtungen kann bzw. können auch von einem elastisch oder plastisch verformbaren Vorsprung an der dem einen Gehäuseteil zugeordneten Stirnseite des Trägers oder von einem elastisch oder plastisch verformbaren Vorsprung an der der einen Stirnseite des Trägers zugeordneten Seite des einen Gehäuseteiles gebildet werden.

Es ist gemäß der Erfindung auch möglich, die Dichtung bzw. die Dichtungen so zwischen Gehäuseteil bzw. Gehäuseteilen und Träger anzuordnen, daß sie einerseits an der äußeren Mantelfläche des Trägers und andererseits an der dieser Mantelfläche des Trägers zugewandten Seite der Wand des Gehäuseteiles anliegt bzw. anliegen.

Die Dichtungen bestehen vorzugsweise aus einem elastisch verformbaren Material. Sie können jedoch auch aus einem plastisch verformbaren Material, wie z. B. einem aufgeschäumten Kunststoffmaterial bestehen.

## Patentansprüche

1. Gehäuse für ein elektrisches Bauteil, mit folgenden Merkmalen:
a) das Gehäuse (21, 1, 7) besteht aus einem ersten Gehäuseteil (21) und einem zweiten Gehäuseteil (1, 7), die miteinander verbindbar sind;
b) es ist ein Träger (27) für das im Gehäuse (21, 1, 7) gelegene elektrische Bauteil (35) vorgesehen;
c) der Träger (27) weist elektrische Anschlußmittel (4, 32) zur abgedichteten Verbindung des im Gehäuse (21, 1, 7) gelegenen elektrischen Bauteiles (35) mit einem außerhalb des Gehäuses (21, 1, 7) gelegenen elektrischen Bauteil auf;
d) es ist ein Befestigungsanschluß zur Befestigung des Gehäuses (21, 1, 7) an einem Montageort vorgesehen;
e) zwischen dem ersten Gehäuseteil (21) und dem Träger (27) ist eine Dichtung (25) angeordnet;
f) das erste Gehäuseteil (21), die Dichtung (25) und der Träger (27) bilden eine geschlossene Kammer für das elektrische Bauteil (35);
g) die Dichtung (25) besteht aus einem elastisch oder plastisch verformbaren Werkstoff;
h) der Befestigungsanschluß (37, 38) ist am ersten Gehäuseteil (21) und/oder am zweiten Gehäuseteil (1, 7) angeordnet;
**gekennzeichnet durch** die folgenden Merkmale:
i) das erste Gehäuseteil (21) und das zweite Gehäuseteil (1, 7) sind direkt oder über ein Zwischenstück miteinander verbindbar;
k) die Höhe des Trägers (27) und die Höhe der Seitenwand bzw. der Seitenwände (7) des Gehäuses (21, 1, 7) ist so bemessen, daß bei geschlossenem Gehäuse (21, 1, 7) die einander zugewandten Seiten der beiden Gehäuseteile (21 und 1, 7) aneinander oder an dem Zwischenstück anliegen, und daß wenigstens zwischen dem ersten Gehäuseteil (21) oder dem zweiten Gehäuseteil (1, 7) und der diesem zugewandten Seite des Trägers (27) ein Spalt verbleibt, der von der Dichtung (25, 30) überbrückt wird.

2. Gehäuse für ein elektrisches Bauteil mit folgenden Merkmalen:
a) das Gehäuse (21, 1, 7) besteht aus einem ersten Gehäuseteil (21) und einem zweiten Gehäuseteil (1, 7), die miteinander verbindbar sind;
b) es ist ein als Rahmen ausgebildeter Träger (27) für das im Gehäuse (21, 1, 7) gelegene elektrische Bauteil (35) vorgesehen;
c) der Träger (27) weist elektrische Anschlußmittel (4, 32) zur abgedichteten Verbindung des im Gehäuse (21, 1, 7) gelegenen elektrischen Bauteils (35) mit einem außerhalb des Gehäuses (21, 1, 7) gelegenen elektrischen Bauteil auf;
d) es ist ein Befestigungsanschluß zur Befestigung des Gehäuses (21, 1, 7) an einem Montageort vorgesehen;
e) zwischen dem ersten Gehäuseteil (21) und dem Träger (27) ist eine erste Dichtung (25) angeordnet;
f) zwischen dem zweiten Gehäuseteil (1, 7) und dem Träger (27) ist eine zweite Dichtung (30) angeordnet;
g) die erste Dichtung (25) und die zweite Dichtung (30) bestehen aus einem elastisch oder plastisch verformbaren Werkstoff;
h) der Befestigungsanschluß (37, 38) ist am ersten Gehäuseteil (21) und/oder am zweiten Gehäuseteil (1, 7) angeordnet;
**gekennzeichnet durch** die folgendes Merkmale:
i) das erste Gehäuseteil (21) und das zweite Gehäuseteil (1, 7) sind direkt oder über ein Zwischenstück miteinander verbindbar;
k) das erste Gehäuseteil (21), die erste Dichtung (25), der Träger (27), die zweite Dichtung (30) und das zweite Gehäuseteil (1, 7) bilden eine geschlossene Kammer (36), in welcher das elektrische Bauteil (35) gelegen ist;
I) die Höhe des Trägers (27) und die Höhe der Seitenwand bzw. der Seitenwände (7) des Gehäuses (21, 1, 7) ist so bemessen, daß bei geschlossenem Gehäuse (21, 1, 7) die einander zugewandten Seiten der beiden Gehäuseteile (21 und 1, 7) aneinander oder an dem Zwischenstück anliegen, und daß wenigstens zwischen dem ersten Gehäuseteil (21) oder dem zweiten Gehäuseteil (1, 7) und der diesem zugewandten Seite des Trägers (27) ein Spalt verbleibt, der von der Dichtung (25, 30) überbrückt wird.

3. Gehäuse nach wenigstens einem der vorhergehenden Ansprüche, **dadurch gekennzeichnet, daß** die dem ersten Gehäuseteil (21) zugewandte Seite des Trägers (27) und/oder die dieser Seite des Trägers (27) zugewandte Seite des ersten Gehäuseteiles (21) eine Dichtkontur (9, 11 bzw. 12, 13) zur Aufnahme der ersten Dichtung (25) aufweisen bzw. aufweist.

4. Gehäuse nach wenigstens einem der vorhergehenden Ansprüche, **dadurch gekennzeichnet, daß** die dem zweiten Gehäuseteil (1, 7) zugewandte Seite des Trägers (27) und/oder die dieser Seite des Trägers (27) zugewandte Seite des zweiten Gehäuseteiles (1, 7) eine Dichtkontur (6) zur Aufnahme der zweiten Dichtung (30) aufweisen bzw. aufweist.

5. Gehäuse nach wenigstens einem der vorhergehenden Ansprüche 3 oder 4, **gekennzeichnet durch** die folgenden Merkmale:
a) die Dichtkontur wenigstens des einen Gehäuseteiles (1, 7) wird von einer nutartigen Vertiefung (6) gebildet, die auf der dem Träger (27) zugewandten Seite einer Stufe (5) der Seitenwand (7) dieses Gehäuseteiles (1, 7) angeordnet ist;
b) die Dichtkontur der diesem Gehäuseteil (1, 7) zugewandten Seite des Trägers (27) wird von der diesem Gehäuseteil (1, 7) zugewandten Stirnfläche des Trägers (27) gebildet.

6. Gehäuse nach wenigstens einem der vorhergehenden Ansprüche 3 oder 4, **gekennzeichnet durch** die folgenden Merkmale:
a) die Dichtkontur wenigstens des einen Gehäuseteiles (21) wird von einer Stufe (12, 13) gebildet, die auf der dem Träger (27) zugewandten Seite eines an diesem Gehäuseteil (21) angeordneten, sich in Richtung auf den Träger (27) zu erstreckenden umlaufenden Vorsprungs (23) angeordnet ist;
b) die der Dichtkontur (12, 13) dieses Gehäuseteiles (21) zugewandte Seite des Trägers (27) weist eine Stufe (9, 11) auf, welche die Dichtkontur für die Seite des Trägers (27) bildet, welche der Dichtkontur (12, 13) dieses Gehäuseteils (21) zugeordnet ist;
c) die Stufe (12, 13) des umlaufenden Vorsprungs (23) ist auf der der Innenseite des Trägers (27) zugewandten Seite des umlaufenden Vorsprungs (23) angeordnet;
d) die Stufe (9, 11) des Trägers (27) ist auf der der Stufe (12, 13) des umlaufenden Vorsprungs (23) zugewandten Seite des Trägers (27) angeordnet.

7. Gehäuse nach Anspruch 6, **gekennzeichnet durch** die folgenden Merkmale:
a) der umlaufende Vorsprung (23) des ersten Gehäuseteiles (21) und der Träger (27) sind so bemessen, daß der Träger (27) den sich auf den Träger (27) zu erstreckenden Schenkel (13) der Stufe (12, 13) des umlaufenden Vorsprungs (23) auf seiner dem Innenraum abgewandten Seite übergreift;
b) das zweite Gehäuseteil (1, 7) und der Träger (27) sind so bemessen, daß die Seitenwand (7) des zweiten Gehäuseteiles den Träger (27) auf seiner Außenseite übergreift.

8. Gehäuse nach wenigstens einem der vorhergehenden Ansprüche, **gekennzeichnet durch** die folgenden Merkmale:
a) der die Stufe (12, 13) aufweisende umlaufende Vorsprung (23) ist am ersten Gehäuseteil (21) angeordnet und begrenzt mit der Stufe (9, 11) der dem ersten Gehäuseteil (21) zugewandten Seite des Trägers (27) den Spalt zur Aufnahme der ersten Dichtung (25);
b) die nutartige Vertiefung (6) ist in der dem Träger (27) zugewandten Stirnseite der Stufe (5) der Seitenwand (7) des zweiten Gehäuseteiles (1, 7) angeordnet und begrenzt mit der dem zweiten Gehäuseteil (1, 7) zugewandten Stirnseite des Trägers (27) den Spalt zur Aufnahme der zweiten Dichtung (30).

9. Gehäuse nach wenigstens einem der vorhergehenden Ansprüche, **gekennzeichnet durch** die folgenden Merkmale:
a) das zweite Gehäuseteil (1, 7) ist topfförmig ausgebildet, wobei die sich auf den Träger (27) zu erstreckende umlaufende Seitenwand (7) des topfförmig ausgebildeten Gehäuseteiles (1, 7) die Stufe (5) aufweist, in der die nutartige Vertiefung (6) angeordnet ist.
b) die der Stufe (5) des zweiten Gehäuseteiles (1, 7) zugewandte Seite des Trägers (27) weist eine Stufe (31, 29) auf,die auf der dem Gehäuseinnenraum zugewandten Seite des Trägers (27) gelegen ist und deren sich in Richtung auf das zweite Gehäuseteil (1, 7) zu erstreckender Schenkel (31) sich in die nutartige Vertiefung (6) des zweiten Gehäuseteiles (1, 7) hineinerstreckt.

10. Gehäuse nach wenigstens einem der vorhergehenden Ansprüche, **dadurch gekennzeichnet, daß** der als Rahmen (27) ausgebildete Träger (27) eine umlaufende Versteifungsrippe (15) aufweist, die sich vom Träger (27) weg in den vom Träger (27) begrenzten Raum hineinerstreckt.

11. Gehäuse nach Anspruch 10, **dadurch gekennzeichnet, daß** an der Versteifungsrippe (15) sich auf das eine der beiden Gehäuseteile (21) bzw. (1, 7) zu erstreckende Stützen (16, 22, 40, 46) angeordnet sind, die als Mittel zum Abstützen des elektrischen Bauteiles (35) dienen.

12. Gehäuse nach wenigstens einem der vorhergehenden Ansprüche, **gekennzeichnet durch** die folgenden Merkmale:
a) an dem Träger (27) ist wenigstens eine Steckerkontur (8) bzw. (28) angeformt, die sich **durch** eine Öffnung (10) bzw. (26) in der umlaufenden Seitenwand (7) des Gehäuses (21, 1, 7) aus dem Gehäuse (21, 1, 7) heraus erstreckt;
b) das elektrische Anschlußmittel ist als Steckerstift (4, 32) oder als Steckerbuchse ausgebildet, der bzw. die in den Träger (27) und die Versteifungsrippe (15) eingeformt ist, wobei der Steckerstift (4, 32) bzw. die Steckerbuchse sich mit seinem bzw. ihrem einen Ende in den von der Steckerkontur (8) bzw. (28) umgebenen Raum und mit seinem bzw. ihrem anderen Ende in die vom Träger (27), der Dichtung (25, 30) und dem Gehäuseteil bzw. Gehäuseteilen (21, 1, 7) begrenzte Kammer (36) hineinerstreckt;
c) die Versteifungsrippe (15) weist im Bereich des Steckerstiftes (4, 32) bzw. der Steckerbuchse auf ihrer dem ersten Gehäuseteil (21) und/oder dem zweiten Gehäuseteil (1, 7) zugewandten Seite wenigstens eine fensterartige Öffnung (14, 24) auf, **durch** welche der in diesem Bereich gelegene Teil des Steckerstiftes (4, 32) bzw. der Steckerbuchse zugänglich ist.

13. Gehäuse nach Anspruch 12, **dadurch gekennzeichnet, daß** der Steckerstift (4, 32) bzw. die Steckerbuchae in Richtung auf das elektrische Bauteil (35) zu abgewinkelt ist.

14. Gehäuse nach wenigstens einem der vorhergehenden Ansprüche, **gekennzeichnet durch** die folgenden Merkmale:
a) das elektrische Bauteil (35) weist im Bereich wenigstens einer der Stützen (16, 22, 40, 46) ein elektrisch leitendes Kontaktmittel auf;
b) das elektrisch leitende Kontaktmittel ist auf einer Seite des elektrischen Bauteiles (35) angeordnet, die dem ersten Gehäuseteil (21) oder dem zweiten Gehäuseteil (1, 7) zugewandt ist, wobei das betreffende Gehäuseteil (21, 1, 7) in diesem Bereich so ausgebildet ist, daß es am elektrisch leitenden Kontaktmittel anliegt und mit diesem eine elektrisch leitende Verbindung zwischen Gehäuse (21, 1, 7) und dem elektrischen Bauteil (35) bildet.

15. Gehäuse nach wenigstens einem der vorhergehenden Ansprüche, **gekennzeichnet durch** die folgenden Merkmale:
a) an dem Gehäuseteil (1, 7), auf welches sich die Stützen (16, 22, 40, 46) zu erstrecken, sind gegenüber diesen Stützen (16, 22, 40, 46) gelegene Vorsprünge (2, 34) angeordnet, die sich auf die Stützen (16, 22, 40, 46) zu erstrecken;
b) die Vorsprünge (2, 34) und die Stützen (16, 22, 40, 46) sind in ihrer axialen Erstreckung so bemessen, daß sie nach dem Herstellen der Verbindung von Träger (27) und Gehäuseteil (1, 7) mit ihren dem elektrischen Bauteil (35) zugewandten Stirnseiten an diesem anliegen;
c) das elektrisch leitende Kontaktmittel ist im Bereich einer der Vorsprünge (2, 34) am elektrischen Bauteil (35) angeordnet und bildet mit diesem die elektrisch leitende Verbindung zwischen Gehäuse (21, 1, 7) und elektrischem Bauteil (35).

16. Gehäuse nach wenigstens einem der vorhergehenden Ansprüche, **dadurch gekennzeichnet, daß** das elektrische Bauteil (35) als Leiterplatte ausgebildet ist, die Öffnungen aufweist, mit welchen sie auf Abstufungen (3, 33, 39, 43) der Stützen (16, 22, 40, 46) aufgeschoben ist, wobei das elektrisch leitende Kontaktmittel auf der den Vorsprüngen (2, 34) zugewandten Seite der Leiterplatte im Bereich wenigstens einer der Öffnungen der Leiterplatte an der Leiterplatte angeordnet ist.

17. Gehäuse nach wenigstens einem der vorhergehenden Ansprüche, **gekennzeichnet durch** die folgenden Merkmale:
a) die Versteifungsrippe (15) weist eine Ausnehmung (20) auf;
b) an dem ersten Gehäuseteil (21) oder dem zweiten Gehäuseteil (1, 7) ist ein als Kühlkörper dienender Vorsprung aus einem metallischen Werkstoff angeordnet, der sich **durch** die Ausnehmung (20) hin**durch** oder zumindest in diese hinein in Richtung auf das elektrische Bauteil (35) zu erstreckt;
c) am elektrischen Bauteil (35) ist ein Kontaktelement angeordnet, welches an dem Vorsprung anliegt.

18. Gehäuse nach wenigstens einem der vorhergehenden Ansprüche, **dadurch gekennzeichnet, daß** das erste Gehäuseteil (21) oder das zweite Gehäuseteil (1, 7) von einem Gehäuseteil eines Gerätes gebildet wird.

19. Gehäuse nach wenigstens einem der vorhergehenden Ansprüche, **dadurch gekennzeichnet, daß** die Dichtung (25, 30) von einem elastisch oder plastisch verformbaren Vorsprung an der dem einen Gehäuseteil (21 bzw. 1, 7) zugeordneten Stirnseite des Trägers (27) gebildet wird.

20. Gehäuse nach wenigstens einem der vorhergehenden Ansprpüche, **dadurch gekennzeichnet, daß** die Dichtung von einem elastisch oder plastisch verformbaren Vorsprung an der der einen Stirnseite des Trägers (27) zugeordneten Seite des einen Gehäuseteils (21 bzw. 1, 7) gebildet wird.

21. Gehäuse nach wenigstens einem der vorhergehenden Ansprpüche, **dadurch gekennzeichnet, daß** das Zwischenstück aus einem starren Werkstoff besteht.

## Claims

1. Housing for an electrical component, having the following features:
a) the housing (21, 1, 7) consists of a first housing member (21) and a second housing member (1, 7), which are connectible to one another;
b) a support (27) is provided for the electrical component (35) situated in the housing (21, 1, 7);
c) the support (27) has electrical connection means (4, 32) for the sealed connection of the electrical component (35) situated in the housing (21, 1, 7) to an electrical component situated outside the housing (21, 1, 7);
d) a securing means is provided for securing the housing (21, 1, 7) to a mounting site;
e) a seal (25) is arranged between the first housing member (21) and the support (27);
f) the first housing member (21), the seal (25) and the support (27) form a closed chamber for the electrical component (35);
g) the seal (25) consists of a resiliently or plastically deformable material;
h) the securing means (37, 38) is arranged on the first housing member (21) and/or on the second housing member (1, 7);
**characterised by** the following features:
i) the first housing member (21) and the second housing member (1, 7) are connectible to one another directly or by way of an intermediate piece;
k) the height of the support (27) and the height of the side wall(s) (7) of the housing (21, 1, 7) are such that, when the housing (21, 1, 7) is closed, the facing sides of the two housing members (21 and 1, 7) rest against one another or against the intermediate piece and that a gap is left at least between the first housing member (21) or the second housing member (1, 7) and the side of the support (27) that faces it, which gap is bridged by the seal (25, 30).

2. Housing for an electrical component, having the following features:
a) the housing (21, 1, 7) consists of a first housing member (21) and a second housing member (1, 7), which are connectible to one another;
b) a support (27), in the form of a frame, is provided for the electrical component (35) situated in the housing (21, 1, 7);
c) the support (27) has electrical connection means (4, 32) for the sealed connection of the electrical component (35) situated in the housing (21, 1, 7) to an electrical component situated outside the housing (21, 1, 7);
d) a securing means is provided for securing the housing (21, 1, 7) to a mounting site;
e) a first seal (25) is arranged between the first housing member (21) and the support (27);
f) a second seal (30) is arranged between the second housing member (1, 7) and the support (27);
g) the first seal (25) and the second seal (30) consist of a resiliently or plastically deformable material;
h) the securing means (37, 38) is arranged on the first housing member (21) and/or on the second housing member (1, 7);
**characterised by** the following features:
i) the first housing member (21) and the second housing member (1, 7) are connectible to one another directly or by way of an intermediate piece;
k) the first housing member (21), the first seal (25), the support (27), the second seal (30) and the second housing member (1, 7) form a closed chamber (36) in which the electrical component (35) is situated;
l) the height of the support (27) and the height of the side wall(s) (7) of the housing (21, 1, 7) are such that, when the housing (21, 1, 7) is closed, the facing sides of the two housing members (21 and 1, 7) rest against one another or against the intermediate piece and that a gap is left at least between the first housing member (21) or the second housing member (1, 7) and the side of the support (27) that faces it, which gap is bridged by the seal (25, 30).

3. Housing according to at least one of the preceding claims, **characterised in that** the side of the support (27) that faces the first housing member (21) and/or the side of the first housing member (21) that faces that side of the support (27) have or has a shaped sealing portion (9, 11 and 12, 13) for receiving the first seal (25).

4. Housing according to at least one of the preceding claims, **characterised in that** the side of the support (27) that faces the second housing member (1, 7) and/or the side of the second housing member (1, 7) that faces that side of the support (27) have or has a shaped sealing portion (6) for receiving the second seal (30).

5. Housing according to at least one of preceding claims 3 and 4, **characterised by** the following features:
a) the shaped sealing portion at least of the one housing member (1, 7) is formed by a groove-like depression (6) which is arranged in a step (5) of the side wall (7) of that housing member (1, 7) on the side facing the support (27);
b) the shaped sealing portion of the side of the support (27) that faces that housing member (1, 7) is formed by the end face of the support (27) that faces that housing member (1, 7).

6. Housing according to at least one of preceding claims 3 and 4, **characterised by** the following features:
a) the shaped sealing portion at least of the one housing member (21) is formed by a step (12, 13) which is arranged on the side facing the support (27) of a peripheral projection (23) which is arranged on that housing member (21) and extends in the direction towards the support (27);
b) the side of the support (27) that faces the shaped sealing portion (12, 13) of that housing member (21) has a step (9, 11) which forms the shaped sealing portion for the side of the support (27) that is associated with the shaped sealing portion (12, 13) of that housing member (21);
c) the step (12, 13) of the peripheral projection (23) is arranged on the side of the peripheral projection (23) that faces the inner side of the support (27);
d) the step (9, 11) of the support (27) is arranged on the side of the support (27) that faces the step (12, 13) of the peripheral projection (23).

7. Housing according to claim 6, **characterised by** the following features:
a) the peripheral projection (23) of the first housing member (21) and the support (27) are so configured that the support (27) engages over the limb (13) of the step (12, 13) of the peripheral projection (23), which limb (13) extends towards the support (27), on its side remote from the interior;
b) the second housing member (1, 7) and the support (27) are so configured that the side wall (7) of the second housing member engages over the support (27) on its outer side.

8. Housing according to at least one of the preceding claims, **characterised by** the following features:
a) the peripheral projection (23) having the step (12, 13) is arranged on the first housing member (21) and, together with the step (9, 11) of the side of the support (27) that faces the first housing member (21), defines the gap for receiving the first seal (25);
b) the groove-like depression (6) is arranged in the step (5) of the side wall (7) of the second housing member (1, 7) on its end face facing the support (27) and, together with the end face of the support (27) that faces the second housing member (1, 7), defines the gap for receiving the second seal (30).

9. Housing according to at least one of the preceding claims, **characterised by** the following features:
a) the second housing member (1, 7) is pot-shaped, the peripheral side wall (7) of the pot-shaped housing member (1, 7), which side wall (7) extends towards the support (27), having the step (5) in which the groove-like depression (6) is arranged;
b) the side of the support (27) that faces the step (5) of the second housing member (1, 7) has a step (31, 29) which is situated on the side of the support (27) that faces the interior of the housing and the limb (31) of which, which extends in the direction towards the second housing member (1, 7), extends into the groove-like depression (6) of the second housing member (1, 7).

10. Housing according to at least one of the preceding claims, **characterised in that** the support (27), which is in the form of a frame (27), has a peripheral strengthening rib (15) which extends away from the support (27) into the space defined by the support (27).

11. Housing according to claim 10, **characterised in that** on the strengthening rib (15) there are arranged connection pieces (16, 22, 40, 46) extending towards one of the two housing members (21) and (1, 7), which connection pieces (16, 22, 40, 46) serve as means for supporting the electrical component (35).

12. Housing according to at least one of the preceding claims, **characterised by** the following features:
a) there is formed integrally with the support (27) at least one shaped connector (8) and/or (28), which extends out of the housing (21, 1, 7) through an opening (10) and (26), respectively, in the peripheral side wall (7) of the housing (21, 1, 7);
b) the electrical connection means is in the form of a pin connector (4, 32) or in the form of a socket connector, which is formed integrally in the support (27) and the strengthening rib (15), one end of the pin connector (4, 32) or of the socket connector extending into the space enclosed by the shaped connector (8) and (28), respectively, and the other end extending into the chamber (36) defined by the support (27), the seal (25, 30) and the housing member(s) (21, 1, 7);
c) the strengthening rib (15) has in the region of the pin connector (4, 32) or the socket connector, on its side facing the first housing member (21) and/or the second housing member (1, 7), at least one window-like opening (14, 24) through which the portion of the pin connector (4, 32) or of the socket connector situated in that region is accessible.

13. Housing according to claim 12, **characterised in that** the pin connector (4, 32) or the socket connector is angularly formed so as to extend in the direction towards the electrical component (35).

14. Housing according to at least one of the preceding claims, **characterised by** the following features:
a) the electrical component (35) has an electrically conducting contact means in the region of at least one of the connection pieces (16, 22, 40, 46);
b) the electrically conducting contact means is arranged on a side of the electrical component (35) that faces the first housing member (21) or the second housing member (1, 7), the housing member (21, 1, 7) in question being so formed in that region that it rests against the electrically conducting contact means and forms therewith an electrically conducting connection between the housing (21, 1, 7) and the electrical component (35).

15. Housing according to at least one of the preceding claims, **characterised by** the following features:
a) on the housing member (1, 7) towards which the connection pieces (16, 22, 40, 46) extend there are arranged, situated opposite those connection pieces (16, 22, 40, 46), projections (2, 34) which extend towards the connection pieces (16, 22, 40, 46);
b) the projections (2, 34) and the connection pieces (16, 22, 40, 46) are so configured in respect of their axial extent that, after the connection between the support (27) and the housing member (1, 7) has been made, their end faces facing the electrical component (35) rest against that electrical component (35);
c) the electrically conducting contact means is arranged on the electrical component (35) in the region of one of the projections (2, 34) and forms therewith the electrically conducting connection between housing (21, 1, 7) and electrical component (35).

16. Housing according to at least one of the preceding claims, **characterised in that** the electrical component (35) is in the form of a printed circuit board having openings by means of which it is pushed onto shoulders (3, 33, 39, 43) of the connection pieces (16, 22, 40, 46), the electrically conducting contact means being arranged on the printed circuit board, on the side thereof that faces the projections (2, 34), in the region of at least one of the openings of the printed circuit board.

17. Housing according to at least one of the preceding claims, **characterised by** the following features:
a) the strengthening rib (15) has an opening (20);
b) on the first housing member (21) or the second housing member (1, 7) there is arranged a projection, serving as heat sink, made of a metallic material, which projection extends through the opening (20) or at least into the opening (20) in the direction towards the electrical component (35);
c) on the electrical component (35) there is arranged a contact element which rests against the projection.

18. Housing according to at least one of the preceding claims, **characterised in that** the first housing member (21) or the second housing member (1, 7) is formed by a housing member of an appliance.

19. Housing according to at least one of the preceding claims, **characterised in that** the seal (25, 30) is formed by a resiliently or plastically deformable projection on the end face of the support (27) associated with the one housing member (21 or 1, 7).

20. Housing according to at least one of the preceding claims, **characterised in that** the seal is formed by a resiliently or plastically deformable projection on the side of the one housing member (21, or 1, 7) associated with the one end face of the support (27).

21. Housing according to at least one of the preceding claims, **characterised in that** the intermediate piece consists of a rigid material.

## Revendications

1. Boîtier pour un composant électrique, comportant les éléments suivants :
a) le boîtier (21, 1, 7) est constitué par une première partie de boîtier (21) et par une deuxième partie de boîtier (1, 7) qui sont reliées l'une à l'autre ;
b) il est prévu un support (27) pour le composant électrique (35) situé dans le boîtier (21, 1, 7) ;
c) le support (27) comprend des moyens de connexion électriques (4, 32) pour la connexion étanchée du composant électrique (35) situé dans le boîtier (21, 1, 7) avec un composant électrique situé à l'extérieur du boîtier (21, 1, 7) ;
d) on prévoit un raccord de fixation pour fixer le boîtier (21, 1, 7) à un emplacement de montage ;
e) entre la première partie de boîtier (21) et le support (27) est prévu un joint d'étanchéité (25) ;
f) la première partie de boîtier (21), le joint d'étanchéité (25) et le support (27) forment une chambre fermée pour le composant électrique (35) ;
g) le joint d'étanchéité (25) est constitué d'un matériau élastiquement ou plastiquement déformable ;
h) le raccord de fixation (37, 38) est agencé sur la première partie de boîtier (21) et/ou sur la deuxième partie de boîtier (1, 7);
**caractérisé par** les éléments suivants :
i) la première partie de boîtier (21) et la deuxième partie de boîtier (1, 7) peuvent être reliées directement ou via une pièce intermédiaire ;
k) la hauteur du support (27) et la hauteur de la paroi latérale ou des parois latérales (7) du boîtier (21, 1, 7) sont dimensionnées de telle sorte que, lorsque le boîtier (21, 1, 7) est fermé, les faces tournées l'une vers l'autre des deux parties de boîtier (21 et 1, 7) s'appliquent l'une contre l'autre ou contre la pièce intermédiaire, et en ce qu'un intervalle reste au moins entre la première partie de boîtier (21) ou la deuxième partie de boîtier (1, 7) et la face tournée vers celle-ci du support (27), intervalle qui est comblé par le joint d'étanchéité (25, 30).

2. Boîtier pour un composant électrique, comportant les éléments suivants :
a) le boîtier (21, 1, 7) est constitué par une première partie de boîtier (21) et par une deuxième partie de boîtier (1, 7) qui sont reliées l'une à l'autre ;
b) il est prévu un support (27) réalisé sous forme de cadre pour le composant électrique (35) situé dans le boîtier (21, 1, 7) ;
c) le support (27) comprend des moyens de connexion électriques (4, 32) pour la connexion étanchée du composant électrique (35) situé dans le boîtier (21, 1, 7) avec un composant électrique situé à l'extérieur du boîtier (21, 1, 7);
d) on prévoit un raccord de fixation pour fixer le boîtier (21, 1, 7) à un emplacement de montage ;
e) entre la première partie de boîtier (21) et le support (27) est prévu un premier joint d'étanchéité (25) ;
f) entre la deuxième partie de boîtier (1, 7) et le support (27) est prévu un deuxième joint d'étanchéité (30) ;
g) le premier joint (25) et le deuxième joint (30) sont constitués d'un matériau élastiquement ou plastiquement déformable ;
h) le raccord de fixation (37, 38) est agencé sur la première partie de boîtier (21) et/ou sur la deuxième partie de boîtier (1, 7) ;
**caractérisé par** les éléments suivants :
i) la première partie de boîtier (21) et la deuxième partie de boîtier (1, 7) peuvent être reliées directement ou via une pièce intermédiaire ;
k) la première partie de boîtier (21), le premier joint (25), le support (27), le deuxième joint (30) et la deuxième partie de boîtier (1, 7) forment une chambre fermée (36) dans laquelle se trouve le composant électrique (35) ;
l) la hauteur du support (27) et la hauteur de la paroi latérale ou des parois latérales (7) du boîtier (21, 1, 7) sont dimensionnées de telle sorte que, lorsque le boîtier (21, 1, 7) est fermé, les faces tournées l'une vers l'autre des deux parties de boîtier (21 et 1, 7) s'appliquent l'une contre l'autre ou contre la pièce intermédiaire, et en ce qu'un intervalle reste au moins entre la première partie de boîtier (21) ou la deuxième partie de boîtier (1, 7) et la face tournée vers celle-ci du support (27), intervalle qui est comblé par le joint d'étanchéité (25, 30).

3. Boîtier selon l'une au moins des revendications précédentes, **caractérisé en ce que** la face du support (27) tournée vers la première partie de boîtier (21) et/ou la face, tournée vers cette face du support (27); de la première partie de boîtier (21) présente(nt) un contour d'étanchéité (9, 11 ou 12, 13) pour recevoir le premier joint (25).

4. Boîtier selon l'une au moins des revendications précédentes, **caractérisé en ce que** la face du support (27) tournée vers la deuxième partie de boîtier (1, 7) et/ou la face, tournée vers cette face du support (27), de la deuxième partie de boîtier (1, 7) présente(nt) un contour d'étanchéité (6) pour recevoir le deuxième joint (30).

5. Boîtier selon l'une ou l'autre des revendications 3 et 4, **caractérisé par** les éléments suivants :
a) le contour d'étanchéité de l'une au moins des parties de boîtier (1, 7) est formé par un renfoncement (6) en forme de gorge, qui est prévu sur la face, tournée vers le support (27), d'un gradin (5) de la paroi latérale (7) de cette partie de boîtier (1, 7);
b) le contour d'étanchéité de la face du support (27) tournée vers cette partie de boîtier (1, 7) est formé par la surface frontale du support (27) tournée vers cette partie de boîtier (1, 7);

6. Boîtier selon l'une ou l'autre des revendications 3 et 4, **caractérisé par** les éléments suivants :
a) le contour d'étanchéité de l'une au moins des parties de boîtier (21) est formé par un gradin (12, 13) qui est agencé sur une face, tournée vers le support (27), d'une saillie périphérique (23) qui est agencée sur cette partie de boîtier (21) et qui s'étend en direction du support (27) ;
b) la face du support (27) tournée vers le contour d'étanchéité (12, 13) de cette partie de boîtier (21) comprend un gradin (9, 11) qui forme le contour d'étanchéité pour la face du support (27) qui est associée au contour d'étanchéité (12, 13) de cette partie de boîtier (21) ;
c) le gradin (12, 13) de la saillie périphérique (23) est agencé sur la face de la saillie périphérique (23), qui est tournée vers la face intérieure du support (27) ;
d) le gradin (9, 11) du support (27) est agencé sur la face du support (27) tournée vers le gradin (12, 13) de la saillie périphérique (23).

7. Boîtier selon la revendication 6, **caractérisé par** les éléments suivants :
a) la saillie périphérique (23) de la première partie de boîtier (21) et le support (27) sont dimensionnés de telle sorte que le support (27) coiffe le bras (13), s'étendant vers le support (27), du gradin (12, 13) de la saillie périphérique (23) sur sa face détournée du volume intérieur ;
b) la deuxième partie de boîtier (1, 7) et le support (27) sont dimensionnés de telle sorte que la paroi latérale (7) de la deuxième partie de boîtier coiffe le support (27) sur sa face extérieure.

8. Boîtier selon l'une au moins des revendications précédentes, **caractérisé par** les éléments suivants :
a) la saillie périphérique (23) comprenant le gradin (12, 13) est agencée sur la première partie de boîtier (21) et délimite avec le gradin (9, 11) de la face du support (27) tournée vers la première partie de boîtier (21) l'intervalle pour recevoir le premier joint (25) ;
b) le renfoncement (6) en forme de gorge est ménagé dans la face frontale, tournée vers le support (27), du gradin (5) de la paroi latérale (7) de la deuxième partie de boîtier (1, 7) et délimite avec la face du support (27) tournée vers la deuxième partie de boîtier (1, 7) l'intervalle pour recevoir le deuxième joint (30).

9. Boîtier selon l'une au moins des revendications précédentes, **caractérisé par** les éléments suivants :
a) la deuxième partie de boîtier (1, 7) est réalisée en forme de pot, et la paroi latérale périphérique (7), s'étendant vers le support (27), de la partie de boîtier (1, 7) réalisée en forme de pot comprend le gradin (5) dans lequel est ménagé le renfoncement (6) en forme de gorge ;
b) la face du support (27) tournée vers le gradin (5) de la deuxième partie de boîtier (1, 7) comprend un gradin (31, 29) qui est situé sur la face du support (27) tournée vers le volume intérieur du boîtier et dont le côté (31) s'étendant en direction de la deuxième partie de boîtier (1, 7) s'étend jusque dans le renfoncement (6) en forme de gorge de la deuxième partie de boîtier (1, 7).

10. Boîtier selon l'une au moins des revendications précédentes, **caractérisé en ce que** le support (27) réalisé sous forme de cadre (27) comprend une nervure de rigidification périphérique (15) qui s'étend en éloignement du support (27) jusque dans le volume délimité par le support (27).

11. Boîtier selon la revendication 10, **caractérisé en ce qu'**il est prévu sur la nervure de rigidification (15) des montants (16, 22, 40, 46) qui s'étendent vers l'une des deux parties de boîtier (21) ou (1, 7) et qui servent de moyen pour soutenir le composant électrique (35).

12. Boîtier selon l'une au moins des revendications précédentes, **caractérisé par** les éléments suivants :
a) au moins un contour d'enfichage (8) ou (28) est conformé sur le support (27), qui s'étend hors du boîtier (21, 1, 7) à travers une ouverture (10) ou (26) dans la paroi latérale périphérique (7) du boîtier (21, 1, 7) ;
b) le moyen de connexion électrique est réalisé sous forme de tige d'enfichage (4, 32) ou sous forme de douille d'enfichage qui est conformée dans le support (27) et dans la nervure de rigidification (15), et la tige d'enfichage (4, 32) ou la douille d'enfichage s'étend par l'une de ses extrémités jusque dans l'espace entouré par le contour d'enfichage (8) ou (28) et par son autre extrémité jusque dans la chambre (36) délimitée par le support (27), par le joint (25, 30) et par la partie de boîtier ou par les parties de boîtier (21, 1, 7) ;
c) la nervure de rigidification (15) présente dans la zone de la tige d'enfichage (4, 32) ou de la douille d'enfichage, sur sa face tournée vers la première partie de boîtier (21) et/ou vers la deuxième partie de boîtier (1, 7), au moins une ouverture (14, 24) en forme de fenêtre à travers laquelle la partie, située dans cette zone, de la tige d'enfichage (4, 32) ou de la douille d'enfichage est accessible.

13. Boîtier selon la revendication 12, **caractérisé en ce que** la tige d'enfichage (4, 32) ou la douille d'enfichage est coudée en direction du composant électrique (35).

14. Boîtier selon l'une au moins des revendications précédentes, **caractérisé par** les éléments suivants :
a) le composant électrique (35) comprend dans la zone de l'un au moins des montants (16, 22, 40, 46) un moyen de contact électriquement conducteur ;
b) le moyen de contact électriquement conducteur est agencé sur un côté du composant électrique (35) qui est tourné vers la première partie de boîtier (21) ou vers la deuxième partie de boîtier (1, 7), et la partie de boîtier concernée (21, 1, 7) est réalisée dans cette zone de telle sorte qu'elle s'applique contre le moyen de contact électriquement conducteur et établit avec celui-ci une connexion électriquement conductrice entre le boîtier (21, 1, 7) et le composant électrique (35).

15. Boîtier selon l'une au moins des revendications précédentes, **caractérisé par** les éléments suivants :
a) il est prévu, sur la partie de boîtier (1, 7) vers laquelle s'étendent les montants (16, 22, 40, 46), des saillies (2, 34) situées à l'opposé de ces montants (16, 22, 40, 46), lesquelles s'étendent vers les montants (16, 22, 40, 46) ;
b) les saillies (2, 34) et les montants (16, 22, 40, 46) sont dimensionnés à l'égard de leur extension axiale de telle sorte qu'ils s'appliquent, après établissement de la liaison du support (27) et de la partie de boîtier (1, 7) par leurs faces frontales tournées vers le composant électrique (35) contre celui-ci ;
c) le moyen de contact électriquement conducteur est agencé dans la zone de l'une des saillies (2, 34) sur le composant électrique (35) et forme conjointement avec celui-ci la liaison électriquement conductrice entre le boîtier (21, 1, 7) et le composant électrique (35).

16. Boîtier selon l'une au moins des revendications précédentes, **caractérisé en ce que** le composant électrique (35) est réalisé sous forme de carte imprimée qui présente des ouvertures par lesquelles elle est enfilée sur des gradins (3, 33, 39, 43) des montants (16, 22, 40, 46), et le moyen de contact électriquement conducteur est agencé sur la carte imprimée sur la face de la carte imprimée tournée vers les saillies (2, 34) dans la zone de l'une au moins des ouvertures de la carte imprimée.

17. Boîtier selon l'une au moins des revendications précédentes, **caractérisé par** les éléments suivants :
a) la nervure de rigidification (15) présente un évidement (20) ;
b) il est prévu, sur la première partie de boîtier (21) ou sur la deuxième partie de boîtier (1, 7), une saillie en matériau métallique servant de corps de refroidissement qui traverse l'évidement (20) ou qui s'étend au moins jusque dans celui-ci en direction du composant électrique (35) ;
c) un élément de contact est agencé sur le composant électrique (35) et s'applique contre la saillie.

18. Boîtier selon l'une au moins des revendications précédentes, **caractérisé en ce que** la première partie de boîtier (21) ou la deuxième partie de boîtier (1, 7) est formée par une partie de boîtier d'un appareil.

19. Boîtier selon l'une au moins des revendications précédentes, **caractérisé en ce que** le joint (25, 30) est formé par une saillie élastiquement ou plastiquement déformable sur la face frontale du support (27) tournée vers l'une des parties de boîtier (21 ou 1, 7).

20. Boîtier selon l'une au moins des revendications précédentes, **caractérisé en ce que** le joint est formé par une saillie élastiquement ou plastiquement déformable sur la face, associée à l'une des faces frontales du support (27), de l'une des parties de boîtier (21 ou 1, 7).

21. Boîtier selon l'une au moins des revendications précédentes, **caractérisé en ce que** la pièce intermédiaire est constituée d'un matériau rigide.
